# EUROPEAN PATENT APPLICATION

(11) **EP 2 017 030 A1**
(43) Date of publication of application: **21.01.2009**
(21) Application number: 08012414.2
(22) Date of filing: 09.07.2008
(51) Int. Cl.: B23K 26/06, B23K 26/38, B23K 26/40

(54) **Laser beam processing method**

(30) Priority: 19.07.2007 JP 2007188423
(71) Applicant: Nitto Denko Corporation, Ibaraki-shi, Osaka 567-8680 (JP)
(72) Inventor: Naoyuki, Matsuo, Ibaraki-shi Osaka 567-8680 (JP); Kanji, Nishida, Ibaraki-shi Osaka 567-8680 (JP); Atsushi, Hino, Ibaraki-shi Osaka 567-8680 (JP)
(74) Representative: Grünecker, Kinkeldey, Stockmair & Schwanhäusser Anwaltssozietät

(57) **Abstract**

The laser beam processing method according to the present invention is a laser beam processing method that performs shape processing on a work to a designated depth position using a laser beam, and is **characterized in that** the laser power of the laser beam and the relative moving speed between the work and the laser beam are made to be large, and the number of times of irradiation that is necessary for laser beam processing is made to be small so that the energy per unit length of the laser beam that is optimally set depending on the work is within an energy range that does not allow the work to be pierced even when the laser power increases due to a power fluctuation in the laser beam oscillator.

## Description

### BACKGROUND OF THE INVENTION

### FIELD OF THE INVENTION

The present invention relates to a manufacturing method of laser processed parts for processing works such as various sheet materials, circuit boards, semiconductor wafers, glass substrates, ceramic substrates, metal substrates, semiconductor laser or other light emitting or receiving element substrates, MEMS substrates, semiconductor packages, cloth, leather, paper or the like, by using laser, by cutting, drilling, marking, grooving, scribing, trimming, or other shaping process, and an pressure-sensitive adhesive sheet for laser processing used for this purpose.

### BACKGROUND OF THE INVENTION

As the electronic and electric appliances are reduced in size recently, component parts are also reduced in size and advanced in definition, and high definition and high precision are demanded in processing of parts at processing precision of +/- 50 µm or less. In the conventional press processing or blanking process, the precision is about +/- 100 µm at most, and such demand cannot be satisfied. Therefore, a processing method of various materials using a laser beam attracts attention as a method that makes such high-precision processing possible.

Incidentally, high output and price-reduction of the beam source of the laser beam have been progressed, and a cutting technique of various materials using the laser beam is industrially applied in various fields. For example, Japanese Patent Application Laid-Open No. 2003-33389 discloses that half-cutting is performed using the laser beam on a laminated material in which an adhesive layer is laminated on a support. However, in the case of the half-cutting using the laser beam, there is a case that the laminated material is fully cut completely to the support sheet due to the influence of the output stability of the oscillator of the laser beam, the machinability, and the thickness of the support sheet in the laminated material.

Further, when damage is given to the support sheet during laser processing, even in the case that the laminated material is not fully cut, there is a problem that the support sheet is fractured due to tension loading that is applied during the conveyance of the support sheet, with the damage given to the support sheet during laser processing as the starting point of the fracture.

### SUMMARY OF THE INVENTION

The present invention is in view of the conventional problems described above, and its objective is to provide a laser beam processing method that is capable of suppressing a decrease of the yield and that can perform a half-cutting processing on a work within a designated tolerance range even in the case that the output stability of the oscillator of the laser beam is not constant and a laser power increases, and the laser beam machined product obtained with the method.

The inventors in the present invention investigated a laser beam processing method, and a laser beam machined product in order to solve the conventional problems described above. As a result, it was found that the etching depth can be kept within the tolerance range and the half-cutting processing can be performed even in the case that the laser beam power of the laser beam oscillator increases and fluctuates, by finding out the relationship of the degree of influence of the incident energy per unit length toward the work, the etching depth, and the power fluctuation, and the present invention was led to completion.

That is, the laser beam processing method according to the present invention is a laser beam processing method that performs shape processing on a work to a designated depth position using a laser beam in order to solve the above-described problems, and is characterized in that the laser power of the laser beam and the relative moving speed between the work and the laser beam are made to be large, and the number of times of irradiation that is necessary for laser beam processing is made to be small so that the energy per unit length of the laser beam that is optimally set depending on the work is within an energy range that does not allow the work to be pierced even when the laser power increases due to a power fluctuation in the laser beam oscillator.

In the case of performing the shape processing on a work to a designated depth position using a laser beam, the laser power of the laser beam, the relative moving speed between the work and the laser beam, the number of times of irradiation, etc., are set for the optimum processing condition depending on the physical properties of the work so that the desired etching depth can be achieved. However, because the output stability of the oscillator of the laser beam is not constant, the laser power of the laser beam may increase due to the fluctuation. As a result, the etching is performed deeper than the desired etching depth, and there is a case that the designated shape processing becomes impossible.

The influence of such power increase is strongest in the case of setting the processing condition so that the number of times of irradiation is large. It is because the etching amount that increases due to the increase of the laser power of the laser beam is added with every irradiation in the case that the number of times of irradiation is large even in the condition of which the energy per unit length is the same value and the etching amount is same. In the present invention, the laser power and the moving speed are made to be large, and the number of times of irradiation that is necessary for laser beam processing is made to be small so that the energy per unit length of the laser beam that is optimally set depending on the work is within an energy range that does not allow the work to be pierced even when the laser power increases due to a power fluctuation in the laser beam oscillator. As a result, because the increase amount of the laser power added in every irradiation is reduced as much as possible even if the laser power increases, the laser beam processing is kept from being performed in which the etching depth exceeds its tolerance range.

In the above-described method, the laser processing is preferably performed by scanning the same region a plurality of times with the laser beam.

Furthermore, the work is preferably a laminated body including a polymer resin layer.

A carbon dioxide laser is preferably used as a beam source of the laser beam.

The laser beam machined product according to the present invention is preferably obtained with the laser beam processing method described above in order to solve the above-described problems.

The present invention has an effect as described below with the means explained above.

That is, according to the present invention, because the laser power and the moving speed are made to be large, and the number of times of irradiation that is necessary for laser beam processing is made to be small so that the energy per unit length of the laser beam that is optimally set depending on the work is within an energy range that does not allow the work to be pierced even when the laser power increases due to a power fluctuation in the laser beam oscillator, and even when the output of the laser beam oscillator is not stable and the laser power increases, the influence of the fluctuation affecting the laser processing of a work can be reduced. As a result, workability improves, and at the same time, an improvement of the yield can be attempted.

### BRIEF DSCRIPTION OF THE DRAWINGS

Fig. 1 is a cross-sectional schematic view showing a state of performing half-cutting processing on a work with the laser beam processing method according to the embodiment of the present invention;

Fig. 2 is a perspective view showing the state of a work on which half-cutting processing is performed with the above-described method;

Fig. 3A shows the etching depth in the case that the processing is performed by making the incident energy per unit length the same value, increasing the laser power, and making the scanning speed high; Fig. 3B shows the etching depth in the case that the processing is performed by decreasing the laser power, and making the scanning speed low;

Fig. 4A shows the etching depth in the case that the laser power is increased when the processing was performed by making the incident energy per unit length the same value, increasing the laser power, and making the scanning speed high;
Fig. 4B shows the etching depth in the case that the laser power is increased when the processing was performed by decreasing the laser power, and making the scanning speed low; and

Fig. 5 is a cross-sectional schematic view showing a polarizing film with a separator as the work.

### DESCRIPTION OF THE EMBODIMENTS

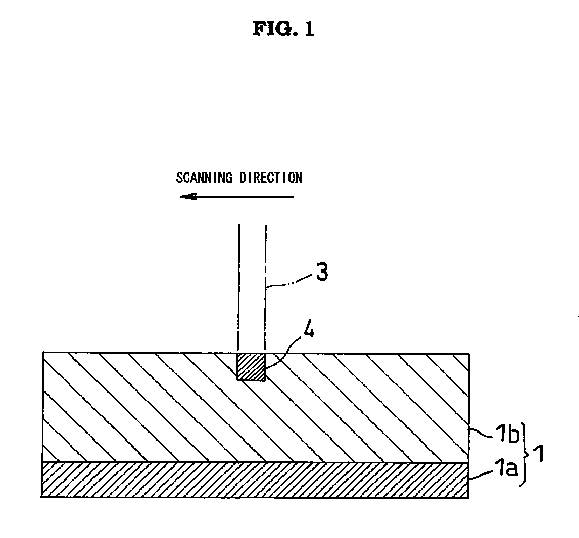

With reference to Figs. 1 to 5, the embodiments of the present invention are explained below. However, parts that are unnecessary in the explanation are omitted, and there are parts shown by magnifying and shrinking, etc. in order to make the explanation easy.

The laser beam processing method according to the present embodiment is a method of performing a laser beam processing method that performs shape processing on a work to a designated depth position using a laser beam with good precision, and it is applicable for a half-cutting processing process, a marking process, a grooving process, a scribing process, etc. for example.

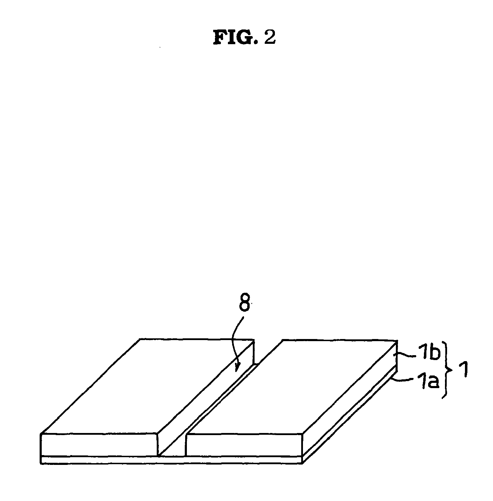

A processing principle of the present invention is explained below in the case of performing half-cutting processing on a work. Fig. 1 is a cross-sectional schematic view showing a state of performing half-cutting processing with a laser beam on a work. Fig. 2 is a perspective view showing the state of a work on which a half-cut part 8 is formed with half-cutting processing. A work 1 used in the present embodiment consists of a laminated body in which a layer to be processed 1b is laminated on a support 1a (detail is described later). The laser beam processing of the work 1 is performed by fixing the work on a chuck plate of a chuck stage. A laser beam 3 output from a designated laser beam oscillator is collected with a lens, and radiated onto the work 1. A half-cutting processing is performed by moving the laser beam irradiation position along on a designated processing line while irradiating. A known method such as a laser beam processing method using galvano scanning or X-Y stage scanning and a mask imaging type laser beam processing process can be used in the half-cutting processing.

The laser beam 3 is not especially limited, and examples that can be used include a third harmonic or a fourth harmonic of an ArF excimer laser, a KrF excimer laser, a XeCl excimer laser, or a YAG laser, the third harmonic or the fourth harmonic of a solid laser of YLF or YVO₄, a Ti:S laser, a semiconductor laser, a fiber laser, and a carbon dioxide laser. Among these laser beams, the carbon dioxide laser is especially preferable in the present invention in respect of improvement of productivity due to its high output.

In the case of performing the half-cutting processing on the work 1 using the laser beam 3, the etching depth is controlled by the incident energy per unit length [J/mm]. The incident energy per unit length can be obtained by dividing the laser power [W] by the scanning speed [mm/s]. Therefore, when the half-cutting processing is performed so that the desired etching depth can be obtained for example, the incident energy per unit length can be adjusted by changing either the laser power or the scanning speed.

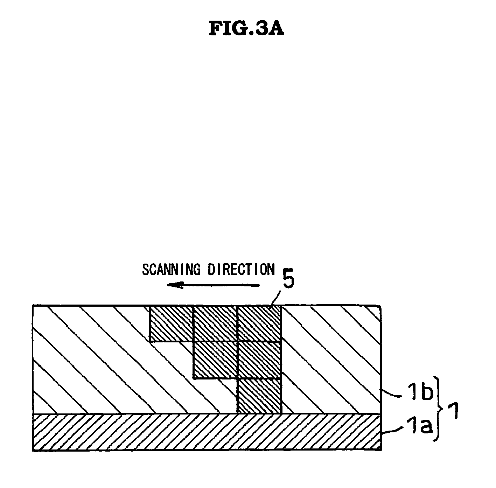

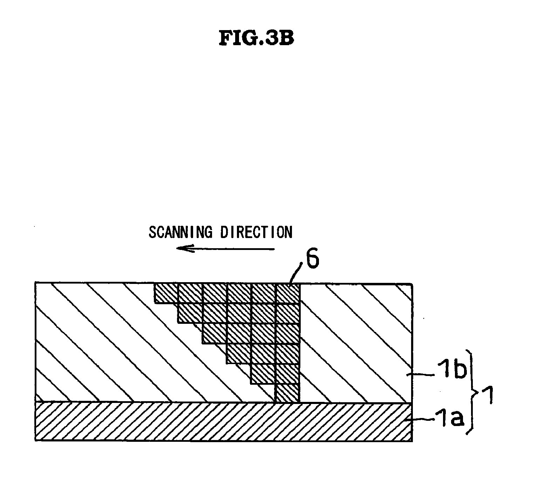

In the case that the half-cutting processing is possible with the desired etching depth when it is performed in a designated condition (that is, the laser power (W), the scanning speed (mm/s), the repeating frequency (MHz), the spot diameter (µmφ), and the number of times of beam laps (pulses) (a value showing how many pulses the laser beam 3 is applied on one particular point where the laser beam scans)), the incident energy per unit length is made to be the same value by making the laser power and the scanning speed large and decreasing the number of times of beam laps in the present invention (refer to Fig. 3A). On the other hand, it is possible to make the incident energy per unit length the same value even by making the laser power and the scanning speed small and increasing the number of times of beam laps (refer to Fig. 3B). Therefore, in the case that the output of the laser beam oscillator is stable, in both cases the etching depth are the same level, and the half-cutting processing is possible with a desired etching depth. However, because the number of times of beam laps is different, it is found that the etching amount per pulse is different even when the final etching amount is same. For example, in the former case, a part that is etched with one pulse becomes an etching part 5 as shown in Fig. 3A. On the other hand, in the latter case, a part that is etched with one pulse becomes an etching part 6 as shown in Fig. 3B.

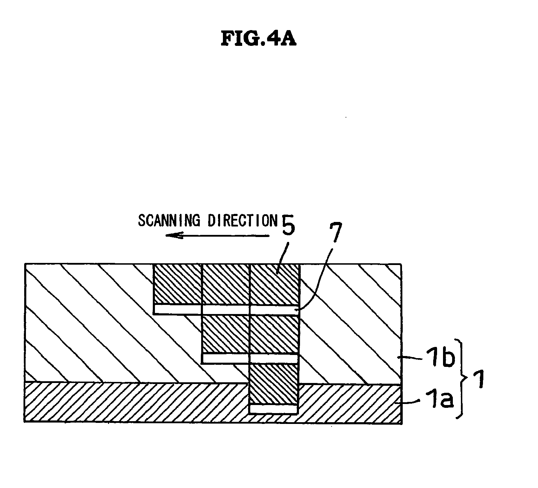

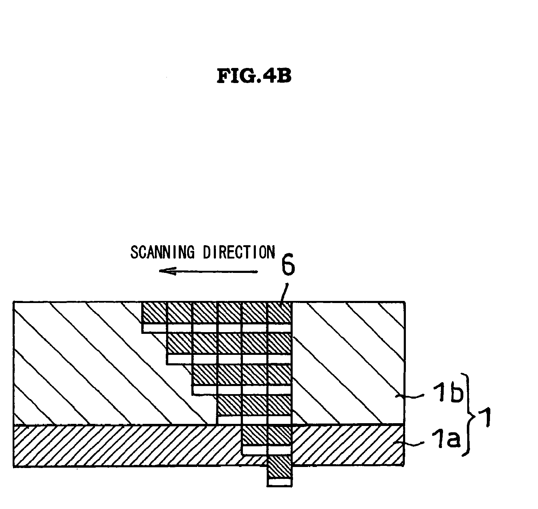

Next, the case is explained in which the output of the oscillator fluctuates and the laser power of the laser beam increases. In this case, an etching part 7 that increases with an increase of the laser power is added every irradiation as shown in Fig. 4 even in the condition that the energy per unit length is the same value and the etching amount becomes same. Because of that, in the case of Fig. 4A in which the number of times of beam laps according to the present invention is small, the laser beam processing extends to a part of the support 1a, and the etching depth becomes deeper than the desired etching depth. However, the work 1 is not completely cut off. On the other hand, in the case of Fig. 4B in which the number of times of beam laps is large, the degree of contribution of the power fluctuation is large, and the work is completely cut off.

As described above, the present invention is that in which the laser power and the scanning speed are made to be large, and the number of times of irradiation necessary for laser beam processing is reduced, so that the energy per unit length of the laser beam 3 that is optimally set depending on the work 1 is within an energy range that does not allow the work 1 to be pierced even when its laser power increases due to a power fluctuation in the oscillator of the laser beam 3. The energy per unit length of the laser beam 3 that is optimally set can be changed appropriately depending on the beam absorption characteristics, the thickness, and thermal characteristics of the work 1. Therefore, it is necessary to optimize the laser beam processing condition every time depending on the constitutional material of the work 1. However, it is important to reduce the degree of the contribution of the laser power of the laser beam 3 toward the etching depth by setting both the laser power and the scanning speed of the laser beam 3 to high values in order to perform the half-cutting processing process without piercing the work even when the laser power increases.

Moreover, the processing condition of other lasers can be appropriately set depending on the types, etc. of the work 1. For example, in the case of applying the laser beam processing method in the present invention to the half-cutting processing, the repeating frequency of the laser beam 3 is not especially limited, and normally it is preferably 1 kHz to 100 kHz. By making it in this range, the productivity can be improved.

The condensed beam diameter of the laser beam 3 can be appropriately set depending on the types of the processing applied to the work 1. In the case of half-cutting processing, the processing width almost corresponds to the condensed beam diameter (the spot diameter) of the laser beam 3. Therefore, control of the processing width becomes possible by adjusting the condensed beam diameter. The condensed beam diameter (the processing width) is preferably normally 10 to 500 µm, and more preferably 100 to 300 µm. When the condensed beam diameter is less than 10 µm, there is a case that a processing speed becomes small. On the other hand, when it exceeds 500 µm, there is a case that the yield from the work decreases.

Further, the laser beam processing may be performed by scanning the same region a plurality of times with the laser beam 3. In this case, the processing condition may be varied with every scan, or the laser beam processing may be performed under the same condition.

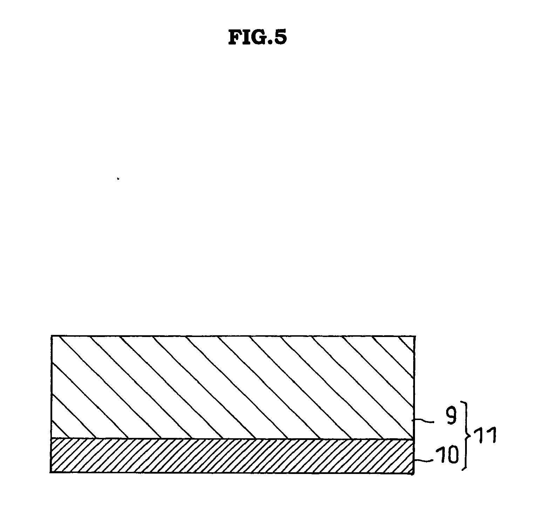

An example of the work 1 that is machined in the present invention is a polarizing film with a separator 11 shown in Fig. 5. The polarizing film with a separator 11 is equipped with a polarizing film (a layer to be machined) 9 configured with a pair of triacetyl cellulose (TAC) films pasted on both surfaces of a polyvinyl alcohol (PVA) film. Furthermore, a separator (support) 10 consisting of a PET film is provided on the side of one of the TAC films through an acrylic adhesive layer. A surface protecting film may be provided on the side of the other TAC film. This surface protecting film has a configuration of which an acrylic adhesive layer is provided on a polyethylene terephthalate (PET) film, and the acrylic adhesive layer becomes a pasting surface to the other TAC film.

Further, works other than the polarizing film with a separator 11 can be applied as the work 1 without special limitation as long as they can be machined with a laser beam. Applicable examples include sheet materials, circuit board, semiconductor wafer, glass substrate, ceramic substrate, metal substrate, semiconductor laser or other light emitting or receiving element substrates, MEMS (micro electro mechanical system) substrates, semiconductor packages, cloth, leather, paper or the like.

Sheet materials include polyimide resin, polyester resin, epoxy resin, urethane resin, polystyrene resin, polyethylene resin, polyamide resin, polycarbonate resin, silicone resin, fluoroplastic resin, macromolecular film, nonwoven cloth, these resins provided with physical or optical functions by drawing process or impregnating process, copper, aluminum, stainless steel, other metal sheets, and polymer sheet and/or metal sheet laminated directly or by way of adhesive or the like.

Circuit boards include one-side or both-side or multilayer flexible printed board, rigid substrate made of glass epoxy, ceramics, metal core substrate or the like, and optical circuit or opto-electrical mixed circuit formed on glass or polymer.

Further, examples of single layer or multi-layer film materials include various adhesive films and optical films.

Preferred examples of this invention will be illustratively described in detail hereinafter. However, materials, blend amounts and others that will be described in the Examples do not limit to this invention unless any restrictive description is particularly included. Thus, these are mere explanatory examples.

### (Example 1)

### [Work]

In the present Example 1, a polarizing film with a separator (total thickness 270 µm) having a configuration shown in Fig. 5 was used as the work, the polarizing film 9 was cut off and machined, and the laser beam machining was done so that the laser beam machining was not performed on the separator 10 (thickness: 38 µm) as the support.

### [Laser Beam Irradiation Apparatus]

The laser beam irradiation apparatus that was used is as follows.

Laser beam source: carbon dioxide laser
Laser wavelength: 10.6 µm
Maximum output: 250 W

### [Laser Beam Irradiation Condition]

The half-cutting machining of the polarizing film with a separator was performed under the following condition.

Laser power: 42 W
Spot diameter: 120 µmφ
Repeating frequency: 20 kHz
Scanning speed: 400 mm/s
Number of scan times: 1 time
Incident energy per unit length: 0.105 J/mm

The half-cutting machining of the polarizing film with a separator was performed in the above-described machining condition. As a result, the laser beam machining could be performed only on the polarizing film 9, and a half-cutting shape was given to the polarizing film with a separator. Next, the range of the laser power that is capable of the half-cutting machining was confirmed by intentionally changing the laser power. As a result, it was found that up to an increased portion of 7 W from an initial value of 42 W is the range that is capable of the half-cutting machining.

### (Comparative Example 1)

The half-cutting machining of the polarizing film with a separator was performed in the same way as Example 1 except the laser power, the scanning speed, and the numbers of times of beam laps were changed as shown in Table 1 in the present Comparative Example 1. Further, the range of the laser power that is capable of the half-cutting machining was confirmed by intentionally changing the laser power. As a result, up to an increased portion of 3.5 W from an initial value of 21 W is the range that is capable of the half-cutting machining, and in the case that the laser power was increased, the laser machining with the laser beam was performed to the separator 10, and it was confirmed that the desired half-cutting is difficult.

### (Comparative Example 2)

The half-cutting machining of the polarizing film with a separator was performed in the same way as Example 1 except the laser power, the scanning speed, and the numbers of times of beam laps were changed as shown in Table 1 in the present Comparative Example 2. Further, the range of the laser power that is capable of the half-cutting machining was confirmed by intentionally changing the laser power. As a result, up to an increased portion of 1.8 W from an initial value of 10.5 W is the range that is capable of the half-cutting machining, and in the case that the laser power was increased, the laser machining with the laser beam was performed to the separator 10, and it was confirmed that the desired half-cutting is difficult.

**Table 1**

| | LASER POWER (W) | SCANNING SPEED (mm/s) | REPEATING FREQUENCY (kHz) | SPOT DIAMETER (µmφ) | NUMBER OF TIMES OF BEAM LAPS (pulses) | INCIDENT ENERGY PER UNIT LENGTH (J/mm) | INCREASED PORTION OF POWER THAT IS CAPABLE OF HALF-CUTTING MACHINING (W) |
|---|---|---|---|---|---|---|---|
| EXAMPLE 1 | 42.0 | 400 | 20 | 120 | 6 | 0.105 | 7.0 |
| COMPARATIVE EXAMPLE 1 | 21.0 | 200 | 20 | 120 | 12 | 0.105 | 3.5 |
| COMPARATIVE EXAMPLE 2 | 10.5 | 100 | 20 | 120 | 24 | 0.105 | 1.8 |

### (Example 2)

In the present Example 2, the polarizing film with a separator 11 (total thickness 270 µm) having a configuration shown in Fig. 5 was used as the work, the polarizing film 9 was cut off and machined, and the laser beam machining was done so that the laser beam machining was not performed on the separator 10 (thickness: 38 µm) as the support.

The same laser beam irradiation apparatus was used as in Example 1, and the number of times of scanning was made to be two times, along with the other laser beam irradiation conditions shown in Table 2 below. Further, in the same manner as Example 1, the range of the laser power that is capable of the half-cutting machining was confirmed by intentionally changing the laser power. As a result, it was found that up to an increased portion of 21 W is the range that is capable of the half-cutting machining.

### (Comparative Example 3)

The half-cutting machining of the polarizing film with a separator was performed in the same way as Example 2 except the laser power, the scanning speed, and the numbers of times of beam laps were changed as shown in Table 2 in the present Comparative Example 3. Further, the range of the laser power that is capable of the half-cutting machining was confirmed by intentionally changing the laser power. As a result, up to an increased portion of 14 W is the range that is capable of the half-cutting machining, and in the case that the laser power was increased, the laser machining with the laser beam was performed to the separator 10, and it was confirmed that the desired half-cutting is difficult.

### (Comparative Example 4)

The half-cutting machining of the polarizing film with a separator was performed in the same way as Example 2 except the laser power, the scanning speed, and the numbers of times of beam laps were changed as shown in Table 2 in the present Comparative Example 4. Further, the range of the laser power that is capable of the half-cutting machining was confirmed by intentionally changing the laser power. As a result, up to an increased portion of 7 W is the range that is capable of the half-cutting machining, and in the case that the laser power was increased, the laser machining with the laser beam was performed to the separator 10, and it was confirmed that the desired half-cutting is difficult.

**Table 2**

| | NUMBER OF TIMES OF IRRADIATION | LASER POWER (W) | SCANNING SPEED (mm/s) | REPEATING FREQUENCY (kHz) | SPOT DIAMETER (µmφ) | NUMBER OF TIMES OF BEAM LAPS (pulses) | INCIDENT ENERGY PER UNIT LENGTH (J/mm) | INCREASED PORTION OF POWER THAT IS CAPABLE OF HALF-CUTTING MACHINING (W) |
|---|---|---|---|---|---|---|---|---|
| EXAMPLE 2 | 1st | 59.0 | 667 | 10 | 120 | 1.8 | 0.089 | 21.0 |
| | 2nd | 42.0 | 2000 | 10 | 120 | 0.6 | 0.021 | |
| COMPARATIVE EXAMPLE 3 | 1st | 59.0 | 667 | 10 | 120 | 1.8 | 0.089 | 14.0 |
| | 2nd | 28.0 | 1333 | 10 | 120 | 0.9 | 0.021 | |
| COMPARATIVE EXAMPLE 4 | 1st | 59 | 667 | 10 | 120 | 1.8 | 0.089 | 7.0 |
| | 2nd | 14.0 | 667 | 10 | 120 | 1.8 | 0.021 | |

## Claims

1. A laser beam processing method that performs shape processing on a work to a designated depth position using a laser beam, wherein the laser power of the laser beam and the relative moving speed between the work and the laser beam are made to be large, and the number of times of irradiation that is necessary for laser beam processing is made to be small so that the energy per unit length of the laser beam that is optimally set depending on the work is within an energy range that does not allow the work to be pierced even when the laser power increases due to a power fluctuation in the laser beam oscillator.

2. The laser beam processing method according to claim 1, wherein the laser processing is performed by scanning the same region a plurality of times with a laser beam.

3. The laser beam processing method according to claims 1 or 2, wherein the work is a laminated body including a polymer resin layer.

4. The laser beam processing method according to any one of claims 1 to 3, wherein a carbon dioxide laser is used as the beam source of the laser beam.

5. A laser beam machined product obtained with the laser beam processing method according to any one of claims 1 to 4.
